# EUROPEAN PATENT APPLICATION

(11) **EP 4 254 487 A1**
(43) Date of publication of application: **04.10.2023**
(21) Application number: 21917655.9
(22) Date of filing: 17.12.2021
(51) Int. Cl.: H01L 23/36, H01L 23/373, C08L 101/00, C09K 5/14, C08K 3/38, H05K 7/20

(54) **HEAT DISSIPATION SHEET AND METHOD FOR PRODUCING HEAT DISSIPATION SHEET**

(30) Priority: 06.01.2021 JP 2021000880
(71) Applicant: Denka Company Limited, Tokyo 103-8338 (JP)
(72) Inventor: WADA, Kosuke, Tokyo 103-8338 (JP); FUJI, Kiyotaka, Tokyo 103-8338 (JP)
(74) Representative: Gulde & Partner
(86) International application number: PCT/JP2021/046743
(87) International publication number: WO 2022/149434

(57) **Abstract**

The heat dissipation sheet according to the present invention is a heat dissipation sheet obtained by molding a heat conductive resin composition containing a resin and a boron nitride powder containing at least an aggregated boron nitride particle formed by an aggregation of hexagonal boron nitride primary particles, the heat dissipation sheet having a partial discharge start voltage of 2800 to 5000 kV/mm. The method for producing the heat dissipation sheet according to the present invention includes a step of blending a resin and a boron nitride powder containing at least an aggregated boron nitride particle formed by an aggregation of hexagonal boron nitride primary particles to prepare a heat conductive resin composition, a step of molding the heat conductive resin composition into a sheet shape to prepare a heat conductive resin composition sheet, and a step of heating and pressurizing the heat conductive resin composition sheet under a vacuum. According to the present invention, a heat dissipation sheet excellent in heat conductivity and insulation property, and a method for producing the heat dissipation sheet excellent in heat conductivity and insulation property can be provided.

## Description

### Technical Field

The present invention relates to a heat dissipation sheet obtained by molding a heat conductive resin composition containing a resin and a boron nitride powder containing at least an aggregated boron nitride particle formed by an aggregation of hexagonal boron nitride primary particles, and a method for producing the heat dissipation sheet.

### Background Art

In heat generating electronic components such as a power device, a transistor, a thyristor, and a CPU, how the heat generated during use thereof is efficiently dissipated is an important issue. Conventionally, as the heat dissipation measure, generally (1) heat conductivity of an insulating layer of a printed-wiring board onto which the heat generating electronic component is to be mounted has been improved, or (2) the heat generating electronic component or a printed-wiring board onto which the heat generating electronic component was mounted has been mounted onto a heat sink via thermal interface materials having electrical insulation properties. As the insulating layer of the printed-wiring board and the thermal interface materials, a silicone resin or an epoxy resin filled with ceramic powder is used.

As the ceramic powder, boron nitride powder having properties such as high heat conductivity, high insulation property, and low relative permittivity is attracting attention. For example, PTL 1 discloses a boron nitride powder formed by an aggregation of primary particles of boron nitride, having a peak A existing in a range of 5 pm or more and less than 30 pm and a peak B existing in a range of 50 pm or more and less than 100 pm, in a particle size distribution based on volume.

### Citation List

### Patent Literature

PTL 1: JP 2020-164365 A

### Summary of Invention

### Technical Problem

Using the boron nitride powder described in PTL 1, a heat dissipation sheet excellent in heat conductivity and insulation property can be obtained. However, in accordance with recent size reduction of electronic devices and increase in heat value of heat generating electronic components, a heat dissipation sheet more excellent in heat conductivity and insulation property is required.

Accordingly, it is an object of the present invention to provide a heat dissipation sheet excellent in heat conductivity and insulation property, and a method for producing the heat dissipation sheet excellent in heat conductivity and insulation property.

### Solution to Problem

The present inventors have intensively studied and have found that a heat dissipation sheet having a partial discharge start voltage falling within a specific range can solve the above problem.

The present invention is based on the above knowledge and its gist is as below.
[1] A heat dissipation sheet obtained by molding a heat conductive resin composition containing a resin and a boron nitride powder containing at least an aggregated boron nitride particle formed by an aggregation of hexagonal boron nitride primary particles,
   the heat dissipation sheet having a partial discharge start voltage of 2800 to 5000 kV/mm.
[2] The heat dissipation sheet according to the above [1], in which the boron nitride powder has a particle size distribution including at least a first maximum point, a second maximum point at which a particle size is larger than at the first maximum point, and a third maximum point at which a particle size is larger than at the second maximum point, the particle size at the first maximum point is 0.4 pm or more and less than 10 pm, the particle size at the second maximum point is 10 pm or more and less than 40 pm, and
   the particle size at the third maximum point is 40 pm or more and 110 pm or less.
[3] The heat dissipation sheet according to the above [2], in which an absolute value of a difference between a particle size at which an integrated quantity of a frequency in the particle size distribution of the boron nitride powder reaches 10%, and a particle size at a minimum point between a maximum point at which a particle size is the smallest and a maximum point at which a particle size is the second smallest in the particle size distribution of the boron nitride powder is 3 to 30 pm.
[4] The heat dissipation sheet according to the above [2] or [3], in which a maximum point adjacent to the first maximum point is the second maximum point, a maximum point adjacent to the second maximum point is the third maximum point, and an absolute value of a difference between a particle size at a first minimum point existing between the first maximum point and the second maximum point, and a particle size at a second minimum point existing between the second maximum point and the third maximum point is 15 to 60 pm.
[5] The heat dissipation sheet according to any one of the above [2] to [4], in which a peak including the third maximum point has a half-value width of 20 to 60 pm.
[6] The heat dissipation sheet according to any one of the above [1] to [5], in which the aggregated boron nitride particle has a crushing strength of 5 to 18 MPa.
[7] A method for producing the heat dissipation sheet according to any one of the above [1] to [6], including a step of blending a resin and a boron nitride powder containing at least an aggregated boron nitride particle formed by an aggregation of hexagonal boron nitride primary particles to prepare a heat conductive resin composition, a step of molding the heat conductive resin composition into a sheet shape to prepare a heat conductive resin composition sheet, and a step of heating and pressurizing the heat conductive resin composition sheet under a vacuum.

### Advantageous Effects of Invention

According the present invention, a heat dissipation sheet excellent in heat conductivity and insulation property, and a method for producing the heat dissipation sheet excellent in heat conductivity and insulation property can be provided.

### Brief Description of Drawings

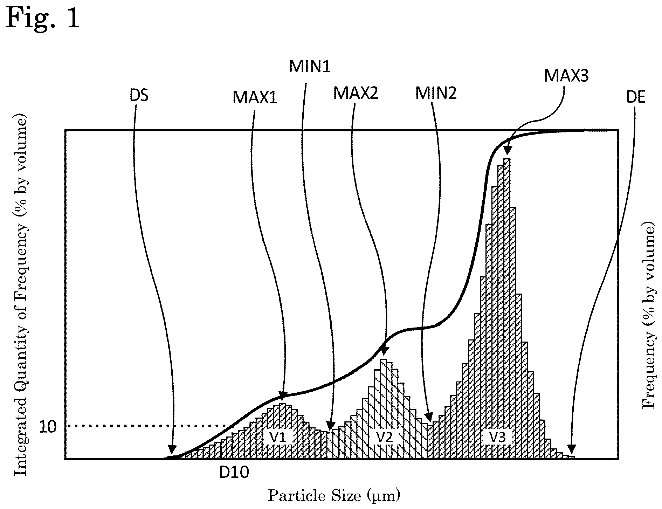

Fig. 1 is a conceptual view of a particle size distribution of boron nitride powder contained in a heat conductive resin composition for a heat dissipation sheet according to the present invention.

### Description of Embodiments

### [Heat Dissipation Sheet]

The heat dissipation sheet according to the present invention is obtained by molding a heat conductive resin composition containing a resin and a boron nitride powder containing at least an aggregated boron nitride particle formed by an aggregation of hexagonal boron nitride primary particles. In addition, the heat dissipation sheet according to the present invention has a partial discharge start voltage of 2800 to 5000 kV/mm. The partial discharge means, when voltage is applied between electrodes, a discharge which occurs partially in an insulating material between the electrodes and does not mean a discharge which completely bridges the electrodes. When the heat dissipation sheet has a partial discharge start voltage of less than 2800 kV/mm, insulation property of the heat dissipation sheet deteriorates. The reason for this is considered to be that, when the heat dissipation sheet has a partial discharge start voltage of less than 2800 kV/mm, excessive voids exist in the heat dissipation sheet. When voids exist in a discharge sheet, an electric field is concentrated in that part and a weak discharge (partial discharge) occurs. When the heat dissipation sheet has a partial discharge start voltage of more than 5000 kV/mm, insulation property of the heat dissipation sheet improves, but heat conductivity deteriorates. The reason for this is considered to be that, when the heat dissipation sheet has a partial discharge start voltage of more than 5000 kV/mm, voids existing in the heat dissipation sheet decreases, but due to a pressurization having been performed in the production of the heat dissipation sheet for decreasing the voids in the heat dissipation sheet, the aggregation of the aggregated boron nitride particles in the heat dissipation sheet was damaged. From the above viewpoints, the heat dissipation sheet according to the present invention has a partial discharge start voltage of preferably 2900 to 4700 kV/mm and more preferably 3000 to 4500 kV/mm. The partial discharge start voltage of the heat dissipation sheet can be measured by the method described in Examples described later. The partial discharge start voltage of the heat dissipation sheet can be controlled by, for example, adjusting a pressure for pressurizing the heat conductive resin composition sheet according to a strength or the like of the aggregated boron nitride particles in the production method of the heat dissipation sheet described later.

### (Boron Nitride Powder)

The boron nitride powder contained in the heat conductive resin composition for the heat dissipation sheet according to the present invention has a particle size distribution preferably including at least: at least one maximum point of a first maximum point at which the particle size is 0.4 pm or more and less than 10 pm and a second maximum point at which the particle size is 10 pm or more and less than 40 µm; and a third maximum point at which the particle size is 40 pm or more and 110 pm or less. In this way, filling property of the boron nitride powder in the heat dissipation sheet can be improved, and therefore the partial discharge start voltage of the heat dissipation sheet can be more easily adjusted to be within the range of 2800 to 5000 kV/mm by adjusting the pressure for pressurizing the heat conductive resin composition sheet in the production method of the heat dissipation sheet described later. From the above viewpoint, the boron nitride powder contained in the heat conductive resin composition for the heat dissipation sheet according to the present invention has a particle size distribution more preferably including at least the first maximum point, the second maximum point, and the third maximum point.

Referring to Fig. 1, the boron nitride powder contained in the heat conductive resin composition for the heat dissipation sheet according to the present invention, having a particle size distribution including the first maximum point, the second maximum point, and the third maximum point will be explained in detail. Fig. 1 is a conceptual view illustrating a particle size distribution of the boron nitride powder contained in the heat conductive resin composition for the heat dissipation sheet according to the present invention. In the particle size distribution illustrated in Fig. 1, the vertical axis is linear and the horizontal axis is logarithmic. The particle size distribution of the boron nitride powder illustrated in Fig. 1 is only a conceptual view and does not limit the boron nitride powder contained in the heat conductive resin composition for the heat dissipation sheet according to the present invention.

The boron nitride powder contained in the heat conductive resin composition for the heat dissipation sheet according to the present invention is a boron nitride powder containing at least an aggregated boron nitride particle formed by an aggregation of hexagonal boron nitride primary particles. In the particle size distribution of the boron nitride powder illustrated in Fig. 1, the sign MAX1 indicates the first maximum point (MAX1), the sign MAX2 indicates the second maximum point, and the sign MAX3 indicates the third maximum point. It is preferable that the particle size at the first maximum point (MAX1) is 0.4 pm or more and less than 10 pm, the particle size at the second maximum point (MAX2) is 10 pm or more and less than 40 pm, and the particle size at the third maximum point (MAX3) is 40 pm or more and 110 pm or less. In this way, filling property of the boron nitride powder in the heat dissipation sheet can be improved, and therefore the partial discharge start voltage of the heat dissipation sheet can be more easily controlled by adjusting the pressure for pressurizing the heat conductive resin composition sheet in the production method of the heat dissipation sheet described later. In addition, filling property of the boron nitride powder in the heat dissipation sheet can be improved in the above way, and therefore heat conductivity of the heat dissipation sheet can be made more excellent. The particle size distribution of the boron nitride powder can be measured by the method of Examples described later.

The particle size at the first maximum point (MAX1) is preferably 0.4 pm or more and less than 10 pm. When the particle size at the first maximum point (MAX1) is 0.4 pm or more and less than 10 pm, filling property of the boron nitride powder in the heat dissipation sheet is improved, and thereby the partial discharge start voltage of the heat dissipation sheet can be more easily controlled and heat conductivity of the heat dissipation sheet can be more improved. From the above viewpoint, the particle size at the first maximum point (MAX1) is more preferably 1.0 to 8.0 pm and further preferably 3.0 to 6.0 pm.

The particle size at the second maximum point (MAX2) is preferably 10 pm or more and less than 40 pm. When the particle size at the second maximum point (MAX2) is 10 pm or more and less than 40 pm, filling property of the boron nitride powder in the heat dissipation sheet is improved, and thereby the partial discharge start voltage of the heat dissipation sheet can be more easily controlled and heat conductivity of the heat dissipation sheet can be more improved. From the above viewpoint, the particle size at the second maximum point (MAX2) is more preferably 15 to 35 pm and further preferably 18 to 30 pm.

The particle size at the third maximum point (MAX3) is preferably 40 pm or more and 110 pm or less. When the particle size at the third maximum point (MAX3) is 40 pm or more and 110 pm or less, filling property of the boron nitride powder in the heat dissipation sheet is improved, and thereby the partial discharge start voltage of the heat dissipation sheet can be more easily controlled and heat conductivity of the heat dissipation sheet can be more improved. From the above viewpoint, the particle size at the third maximum point (MAX3) is more preferably 55 to 95 pm and further preferably 65 to 90 pm.

A maximum point adjacent to the first maximum point (MAX1) is the second maximum point (MAX2), a maximum point adjacent to the second maximum point (MAX2) is the third maximum point (MAX3), and an absolute value of a difference between a particle size at a first minimum point (MIN1) existing between the first maximum point (MAX1) and the second maximum point (MAX2), and a particle size at a second minimum point (MIN2) existing between the second maximum point (MAX2) and the third maximum point (MAX3) is preferably 15 to 60 pm. When the absolute value of the difference between the particle size at the first minimum point (MIN1) and the particle size at the second minimum point (MIN2) is 15 to 60 pm, filling property of the boron nitride powder in the heat dissipation sheet is improved, and thereby the partial discharge start voltage of the heat dissipation sheet can be more easily controlled and heat conductivity of the heat dissipation sheet can be more improved. From the above viewpoint, the absolute value of the difference between the particle size at the first minimum point (MIN1) and the particle size at the second minimum point (MIN2) is more preferably 21 to 43 µm and further preferably 25 to 35 µm.

A peak including the third maximum point (MAX3) has a half-value width of preferably 20 to 60 µm. When the peak including the third maximum point (MAX3) has a half-value width of 20 to 60 µm, filling property of the boron nitride powder in the heat dissipation sheet is improved, and thereby the partial discharge start voltage of the heat dissipation sheet can be more easily controlled and heat conductivity of the heat dissipation sheet can be more improved. From the above viewpoint, the peak including the third maximum point (MAX3) has a half-value width of more preferably 28 to 53 µm and further preferably 40 to 50 µm. The half-value width of the peak including the third maximum point (MAX3) is a width of the peak at a part where a frequency is the half value of the frequency at the third maximum point (MAX3).

An absolute value of a difference between a particle size at which an integrated quantity of a frequency in the particle size distribution of the boron nitride powder reaches 10%, and a particle size at a minimum point between a maximum point at which a particle size is the smallest and a maximum point at which a particle size is the second smallest in the particle size distribution of the boron nitride powder is preferably 3 to 30 µm. For example, in the particle size distribution of the boron nitride powder illustrated in Fig. 1, the sign D10 indicates the particle size at which the integrated quantity of the frequency reaches 10%, the maximum point at which the particle size is the smallest in the particle size distribution of the boron nitride powder is the first maximum point (MAX1), the maximum point at which the particle size is the second smallest in the particle size distribution of the boron nitride powder is the second maximum point (MAX2), and the minimum point between the maximum point at which the particle size is the smallest and the maximum point at which the particle size is the second smallest is the first minimum point (MIN1). When the absolute value of the difference between the above particle sizes is 3 to 30 µm, filling property of the boron nitride powder in the heat dissipation sheet is improved, and thereby the partial discharge start voltage of the heat dissipation sheet can be more easily controlled and heat conductivity of the heat dissipation sheet can be more improved. From the above viewpoint, the absolute value of the difference between the above particle sizes is more preferably 4 to 17 pm and further preferably 6 to 15 pm.

An integrated quantity (V1) of a frequency between a peak start and a peak end in the peak including the first maximum point (MAX1) is preferably 2 to 25% by volume. When the integrated quantity (V1) is 2 to 25% by volume, filling property of the boron nitride powder in the heat dissipation sheet is improved, and thereby the partial discharge start voltage of the heat dissipation sheet can be more easily controlled and heat conductivity of the heat dissipation sheet can be more improved. From the above viewpoint, the integrated quantity (V1) is more preferably 5 to 20% by volume. The peak start in the peak including the first maximum point (MAX1) is a minimum point existing on the side where the particle size is smaller relative to the first maximum point (MAX1). When there is no minimum point on the side where the particle size is smaller relative to the first maximum point (MAX1), the peak start is the end (DS) of the particle size distribution on the side where the particle size is smaller. Further, the peak end in the peak including the first maximum point (MAX1) is a minimum point (MIN1) existing on the side where the particle size is larger relative to the first maximum point (MAX1). The integrated quantity (V1) of the frequency is a value obtained by subtracting the frequency of the particle size at the minimum point (MIN1) existing on the side where the particle size is larger relative to the first maximum point (MAX1) from the integrated quantity of the frequency of from the particle size at the minimum point existing on the side where the particle size is smaller relative to the first maximum point (MAX1) or the particle size at the end (DS) of the particle size distribution on the side where the particle size is smaller to the particle size at the minimum point (MIN1) existing on the side where the particle size is larger relative to the first maximum point (MAX1). Here, the reason for subtracting the frequency of the particle size at the minimum point (MIN1) existing on the side where the particle size is larger relative to the first maximum point (MAX1) is to prevent the frequency of the particle size at the minimum point (MIN1) existing on the side where the particle size is larger relative to the first maximum point (MAX1) from being included in both the integrated quantity of the frequency between the peak start and the peak end in the peak including the first maximum point (MAX1) and an integrated quantity of a frequency between a peak start and a peak end in the peak including the second maximum point (MAX2).

An integrated quantity (V2) of a frequency between a peak start and a peak end in the peak including the second maximum point (MAX2) is preferably 15 to 50% by volume. When the integrated quantity (V2) is 15 to 50% by volume, filling property of the boron nitride powder in the heat dissipation sheet is improved, and thereby the partial discharge start voltage of the heat dissipation sheet can be more easily controlled and heat conductivity of the heat dissipation sheet can be more improved. From the above viewpoint, the integrated quantity (V2) is more preferably 20 to 45% by volume. The peak start in the peak including the second maximum point (MAX2) is a minimum point (MIN1) existing on the side where the particle size is smaller relative to the second maximum point (MAX2). Further, the peak end in the peak including the second maximum point (MAX2) is a minimum point (MIN2) existing on the side where the particle size is larger relative to the second maximum point (MAX2). The integrated quantity (V2) of the frequency is a value obtained by subtracting the frequency of the particle size at the minimum point (MIN2) existing on the side where the particle size is larger relative to the second maximum point (MAX2) from the integrated quantity of the frequency of from the particle size at the minimum point (MIN1) existing on the side where the particle size is smaller relative to the second maximum point (MAX2) to the particle size at the minimum point (MIN2) existing on the side where the particle size is larger relative to the second maximum point (MAX2). Here, the reason for subtracting the frequency of the particle size at the minimum point (MIN2) existing on the side where the particle size is larger relative to the second maximum point (MAX2) is to prevent the frequency of the particle size at the minimum point (MIN2) existing on the side where the particle size is larger relative to the second maximum point (MAX2) from being included in both the integrated quantity of the frequency between the peak start and the peak end in the peak including the second maximum point (MAX2) and an integrated quantity of a frequency between a peak start and a peak end in the peak including the third maximum point (MAX3).

An integrated quantity (V3) of a frequency between a peak start and a peak end in the peak including the third maximum point (MAX3) is preferably 30 to 80% by volume. When the integrated quantity (V3) is 30 to 80% by volume, filling property of the boron nitride powder in the heat dissipation sheet is improved, and thereby the partial discharge start voltage of the heat dissipation sheet can be more easily controlled and heat conductivity of the heat dissipation sheet can be more improved. From the above viewpoint, the integrated quantity (V3) is more preferably 45 to 75% by volume. The peak start in the peak including the third maximum point (MAX3) is a minimum point (MIN2) existing on the side where the particle size is smaller relative to the third maximum point (MAX3). Further, the peak end in the peak including the third maximum point (MAX3) is a minimum point existing on the side where the particle size is larger relative to the third maximum point (MAX3). When there is no minimum point on the side where the particle size is larger relative to the third maximum point (MAX3), the peak end is the end (DE) of the particle size distribution on the side where the particle size is larger. The integrated quantity (V3) of the frequency is a value obtained by subtracting the frequency of the particle size at the minimum point existing on the side where the particle size is larger relative to the third maximum point (MAX3) from the integrated quantity of the frequency of from the particle size at the minimum point (MIN2) existing on the side where the particle size is smaller relative to the third maximum point (MAX3) to the particle size at the minimum point existing on the side where the particle size is larger relative to the third maximum point (MAX3); or the integrated quantity of the frequency of from the particle size at the minimum point (MIN2) existing on the side where the particle size is smaller relative to the third maximum point (MAX3) to the particle size at the end (PE) of the particle size distribution on the side where the particle size is larger. Here, the reason for subtracting the frequency of the particle size at the minimum point existing on the side where the particle size is larger relative to the third maximum point (MAX3) is to prevent the frequency of the particle size at the minimum point existing on the side where the particle size is larger relative to the third maximum point (MAX3) from being included in both the integrated quantity of the frequency between the peak start and the peak end in the peak including the third maximum point (MAX3) and an integrated quantity of a frequency between a peak start and a peak end in a peak including a maximum point, adjacent to the third maximum point (MAX3), existing on the side where the particle size is larger relative to the third maximum point.

In the boron nitride powder contained in the heat conductive resin composition for the heat dissipation sheet according to the present invention, the aggregated boron nitride particles have a crushing strength of preferably 5 to 18 MPa. When the aggregated boron nitride particles have a crushing strength of 5 MPa or more, a damage of the aggregated boron nitride particles during the manufacture of the heat dissipation sheet can be reduced. When the aggregated boron nitride particles have a crushing strength of 18 MPa or less, a resin can sufficiently enter the aggregated boron nitride particles in the heat dissipation sheet, and the air can be prevented from remaining in the aggregated boron nitride particles in the heat dissipation sheet. From the above viewpoints, in the boron nitride powder according to the present invention, the aggregated boron nitride particles have a crushing strength of more preferably 6 to 15 MPa and further preferably 7 to 13 MPa. The crushing strength of the aggregated boron nitride particles can be measured by the method described in Examples described later.

As long as filling property of the boron nitride powder in the heat dissipation sheet is improved, and thereby the partial discharge start voltage of the heat dissipation sheet can be more easily controlled and heat conductivity of the heat dissipation sheet can be more improved, the particle size distribution of the boron nitride powder according to the present invention may have other maximum points in addition to the above first to third maximum points.

### (Method for Producing Boron Nitride Powder)

An example of the method for producing the boron nitride powder contained in the heat conductive resin composition for the heat dissipation sheet according to the present invention will be explained below.

The boron nitride powder contained in the heat conductive resin composition for the heat dissipation sheet according to the present invention can be produced by, for example, preparing each of first boron nitride powder having a particle size distribution including the first maximum point, second boron nitride powder having a particle size distribution including the second maximum point, and third boron nitride powder having a particle size distribution including the third maximum point, and mixing the prepared first to third boron nitride powders.

Among the first to third boron nitride powders, each of the second and third boron nitride powders is preferably boron nitride powder containing at least aggregated boron nitride particles formed by an aggregation of hexagonal boron nitride primary particles. The first boron nitride powder may be the aggregated boron nitride particles but is preferably the hexagonal boron nitride primary particles. The maximum point of each of the first to third boron nitride powders means a peak top in the particle size distribution of each of the first to third boron nitride powders. The particle size distributions of the first to third boron nitride powders are measured in the same manner as the particle size distribution of the boron nitride powder described above.

In the mixing step, the first to third boron nitride powders may be mixed such that the volume proportion of the third boron nitride powder becomes larger than the volume proportion of the second boron nitride powder and the volume proportion of the second boron nitride powder becomes larger than the volume proportion of the first boron nitride powder. In this way, filling property of the boron nitride powder in the heat dissipation sheet is improved, the partial discharge start voltage of the heat dissipation sheet can be more easily controlled, and heat conductivity of the heat dissipation sheet can be improved. The volume proportion of the third boron nitride powder is, relative to 100 parts by volume of the total of the first to third boron nitride powders, preferably 30 to 80 parts by volume, more preferably 45 to 75 parts by volume, and further preferably 50 to 70 parts by volume, from viewpoints of the control of the partial discharge start voltage of the heat dissipation sheet and heat conductivity of the heat dissipation sheet. The volume proportion of the second boron nitride powder is, relative to 100 parts by volume of the total of the first to third boron nitride powders, preferably 15 to 50 parts by volume, more preferably 20 to 45 parts by volume, and further preferably 25 to 35 parts by volume, from viewpoints of the control of the partial discharge start voltage of the heat dissipation sheet and heat conductivity of the heat dissipation sheet. The volume proportion of the first boron nitride powder is, relative to 100 parts by volume of the total of the first to third boron nitride powders, preferably 2 to 25 parts by volume, more preferably 5 to 20 parts by volume, and further preferably 8 to 15 parts by volume, from viewpoints of the control of the partial discharge start voltage of the heat dissipation sheet and heat conductivity of the heat dissipation sheet.

Each of the first to third boron nitride powders can be produced by, for example, a production method including a pulverization step of pulverizing a lump-shaped boron carbide, a nitridation step of nitriding the pulverized boron carbide to obtain boron carbonitride, and a decarburization step of decarburizing the boron carbonitride.

In the pulverization step, a lump-shaped boron carbide (boron carbide lump) is pulverized using a general pulverizer or disintegrator. Here, for example, boron carbide powder having a desired maximum point can be obtained by adjusting a pulverization time and a feeding amount of the boron carbide lump. The maximum point of the boron carbide powder can be measured in the same manner as the maximum point of the boron nitride powder described above. By adjusting the maximum point of the boron carbide powder to reach the desired maximum point of the boron nitride powder, the first to third boron nitride powders having the above-described maximum points can be obtained.

Next, in the nitridation step, boron carbonitride is obtained by firing the boron carbide powder in an atmosphere advancing the nitridation reaction and under a pressurized condition.

The atmosphere in the nitridation step is an atmosphere advancing the nitridation reaction. It may be, for example, nitrogen gas, ammonia gas, etc., and may be one of these alone or a combination of two or more of these. The atmosphere is preferably nitrogen gas from viewpoints of the ease of nitridation and the cost. The nitrogen gas content of the atmosphere is preferably 95% by volume or more and more preferably 99.9% by volume or more.

The pressure in the nitridation step is preferably 0.6 MPa or more and more preferably 0.7 MPa or more, preferably 1.0 MPa or less and more preferably 0.9 MPa or less. The pressure is further preferably 0.7 to 1.0 MPa. Firing temperature in the nitridation step is preferably 1800°C or more and more preferably 1900°C or more, preferably 2400°C or less and more preferably 2200°C or less. The firing temperature is further preferably 1800 to 2200°C. The pressure condition and the firing temperature are preferably 1800°C or more and 0.7 to 1.0 MPa because it is a condition advancing the nitridation of the boron carbide more suitably and being industrially appropriate, too.

Firing time in the nitridation step is appropriately selected in a range where the nitridation proceeds sufficiently, and is preferably 6 hours or more and more preferably 8 hours or more, and may be preferably 30 hours or less and more preferably 20 hours or less.

In the decarburization step, the boron carbonitride obtained in the nitridation step is subjected to a heat treatment of retaining in an atmosphere equal to or above normal pressure at a predetermined retaining temperature for a certain period. In this way, aggregated boron nitride particles formed by an aggregation of decarburized and crystallized hexagonal boron nitride primary particles can be obtained.

The atmosphere in the decarburization step is an atmosphere of normal pressure (atmospheric pressure) or a pressurized atmosphere. In the case of the pressurized atmosphere, the pressure may be, for example, 0.5 MPa or less and preferably 0.3 MPa or less.

In the decarburization step, for example, the temperature is raised to a predetermined temperature (temperature at which the decarburization can start) and it is then further raised to the retaining temperature at a predetermined rate. The predetermined temperature (temperature at which the decarburization can start) can be set according to the system, and, for example, may be 1000°C or more and may be 1500°C or less, and is preferably 1200°C or less. The rate at which the temperature is raised from the predetermined temperature (temperature at which the decarburization can start) to the retaining temperature may be, for example, 5°C/min or less and preferably 4°C/min or less, 3°C/min or less, or 2°C/min or less.

The retaining temperature is preferably 1800°C or more and more preferably 2000°C or more from viewpoints that a particle growth is ready to occur favorably and heat conductivity of the boron nitride powder obtained can be more improved. The retaining temperature may be preferably 2200°C or less and more preferably 2100°C or less.

A retaining time at the retaining temperature is appropriately selected in a range where the crystallization proceeds sufficiently, and may be, for example, more than 0.5 hours. It is preferably 1 hour or more, more preferably 3 hours or more, further preferably 5 hours or more, and particularly preferably 10 hours or more, from a viewpoint that a particle growth is ready to occur favorably. The retaining time at the retaining temperature may be, for example, less than 40 hours. It is preferably 30 hours or less and more preferably 20 hours or less, from viewpoints of preventing the particle growth from proceeding too much to decrease particle strength and reducing the cost.

In the decarburization step, a boron source may be mixed as a raw material in addition to the boron carbonitride obtained in the nitridation step to perform decarburization and crystallization. Examples of the boron source include boric acid, boron oxide, and a mixture thereof. In this case, other additives used in the art may be further used if necessary.

A mixing ratio of the boron carbonitride and the boron source is selected appropriately. When boric acid or boron oxide is used as the boron source, the ratio of the boric acid or the boron oxide may be, for example, 100 parts by mass or more and is preferably 150 parts by mass or more relative to 100 parts by mass of the boron carbonitride. It may be, for example, 300 parts by mass or less and is preferably 250 parts by mass or less relative to 100 parts by mass of the boron carbonitride.

The boron nitride powder obtained as the above may be subjected to a step of classification (classification step) using a sieve such that boron nitride powder having a desired particle size distribution can be obtained. In this way, the first to third boron nitride powders having the desired maximum points can be more suitably obtained.

By mixing the obtained first to third boron nitride powders, the boron nitride powder contained in the heat conductive resin composition for the heat dissipation sheet according to the present invention can be obtained. A mixing method is not particularly limited as long as it can mix the first to third boron nitride powders uniformly. For example, the first to third boron nitride powders may be mixed using a container rotating mixer, the first to third boron nitride powders may be mixed using a fixed container mixer, or the first to third boron nitride powders may be mixed using a fluid motion mixer.

### (Resin)

Examples of the resin contained in the heat conductive resin composition for the heat dissipation sheet according to the present invention include an epoxy resin, a silicone resin (including a silicone rubber), an acrylic resin, a phenolic resin, a melamine resin, a urea resin, an unsaturated polyester, a fluorine resin, a polyamide (for example, a polyimide, a polyamide imide, a polyether imide, etc.), a polyester (for example, a polybutylene terephthalate, a polyethylene terephthalate, etc.), a polyphenylene ether, a polyphenylene sulfide, a wholly aromatic polyester, a polysulfone, a liquid crystal polymer, a polyether sulfone, a polycarbonate, a maleimide-modified resin, an ABS resin, an AAS (acrylonitrile-acrylic rubber-styrene) resin, and an AES (acrylonitrile-ethylene-propylene-diene rubber-styrene) resin. Among these, a silicone resin is preferred from viewpoints of heat resistance, flexibility, and adhesiveness to a heat sink or the like. The silicone resin is preferably vulcanized with an organic peroxide to be cured. The heat conductive resin composition has a viscosity at 25°C of, for example, 100,000 cp or less from a viewpoint of improving flexibility of a sheet-shaped molded body.

In the heat conductive resin composition for the heat dissipation sheet according to the present invention, the boron nitride powder has a content relative to 100% by volume of the total of the boron nitride powder and the resin of preferably 30 to 85% by volume and more preferably 40 to 80% by volume. When the boron nitride powder has a content of 30% by volume or more, heat conductivity improves and a sufficient heat dissipation property is easy to be obtained. When the boron nitride powder has a content of 85% by volume or less, the tendency of voids to form during molding can be reduced and the deterioration of insulation property and mechanical strength can be reduced. The resin component has a content relative to 100% by volume of the total of the boron nitride powder and the resin of preferably 15 to 70% by volume and more preferably 20 to 60% by volume.

### (Solvent)

The heat conductive resin composition may further contain solvent to adjust the viscosity of the heat conductive resin composition. The solvent is not particularly limited as long as it can dissolve the resin and, after applying the heat conductive resin composition, be easily removed from the applied heat conductive resin composition. When the resin is a silicone resin, examples of the solvent include toluene, xylene, and a chlorinated hydrocarbon. Among these solvents, toluene is preferred in a viewpoint of easiness of the removal. A content of the solvent can be selected appropriately according to the aimed viscosity of the heat conductive resin composition. The content of the solvent is, for example, 40 to 200 parts by mass relative to 100 parts by mass of the components of the heat conductive resin composition except for the solvent.

The heat conductive resin composition may contain other components than the boron nitride powder, the resin component, and the solvent. Examples of the other components include an inorganic filler other than the boron nitride powder, an additive, and an impurity. The other components have a content of preferably 5 parts by mass or less, more preferably 3 parts by mass or less, and further preferably 1 part by mass or less relative to 100 parts by mass of the total of the boron nitride powder and the resin.

### (Thickness of Heat Dissipation Sheet)

The heat dissipation sheet according to the present invention has a thickness of preferably 100 to 1200 pm. When the heat dissipation sheet has a thickness of 100 pm or more, the heat dissipation sheet can more securely adhere to heat generating electronic components. When the heat dissipation sheet has a thickness of 1200 pm or less, the heat dissipation property of the heat dissipation sheet can become more favorably. From the above viewpoints, the heat dissipation sheet according to the present invention has a thickness of more preferably 150 to 800 pm and further preferably 200 to 600 pm.

### [Method for Producing Heat Dissipation Sheet]

A method for producing the heat dissipation sheet according to the present invention includes a step (A) of blending a resin and a boron nitride powder containing at least an aggregated boron nitride particle formed by an aggregation of hexagonal boron nitride primary particles to prepare a heat conductive resin composition, a step (B) of molding the heat conductive resin composition into a sheet shape to prepare a heat conductive resin composition sheet, and a step (C) of heating and pressurizing the heat conductive resin composition sheet under a vacuum.

### (Step (A))

In the step (A), the resin and the boron nitride powder containing at least aggregated boron nitride particles formed by an aggregation of hexagonal boron nitride primary particles are blended to prepare the heat conductive resin composition. The boron nitride powder used in the step (A) is preferably the boron nitride powder contained in the heat conductive resin composition for the heat dissipation sheet according to the present invention. The boron nitride powder and the resin used in the step (A) were already explained and therefore their explanation is omitted.

### (Step (B))

In the step (B), the heat conductive resin composition is molded into a sheet shape to prepare a heat conductive resin composition sheet. The heat conductive resin composition can be molded into a sheet shape by, for example, a doctor blade method or a calendering. However, when the heat conductive resin composition passes through calender rolls, the aggregated boron nitride particles in the heat conductive resin composition may be damaged. Therefore, the heat conductive resin composition is preferably molded into a sheet shape with the doctor blade method.

### (Step (C))

In the step (C), the heat conductive resin composition sheet is heated and pressurized under vacuum. By adjusting a pressure for pressurizing the heat conductive resin composition sheet, the partial discharge start voltage of the heat dissipation sheet can be controlled. For example, when the pressure for pressurizing the heat conductive resin composition sheet is increased, the partial discharge start voltage of the heat dissipation sheet increases. However, when the pressure for pressurizing the heat conductive resin composition sheet is increased too much, the aggregation of the aggregated boron nitride particles in the heat conductive resin composition sheet may be damaged. On the other hand, when the pressure for pressurizing the heat conductive resin composition sheet is decreased, the partial discharge start voltage of the heat dissipation sheet decreases. In addition, by heating and pressurizing the heat conductive resin composition sheet under vacuum, microvoids in the heat dissipation sheet can be more reduced. Therefore, heat conductivity of the heat dissipation sheet can be improved and the insulation property of the heat dissipation sheet can be improved, too. Further, by heating and pressurizing the heat conductive resin composition sheet under vacuum, microvoids in the heat dissipation sheet can be reduced even if the pressure for pressurizing the heat conductive resin composition sheet is small. Therefore, the aggregation of the aggregated boron nitride particles in the heat conductive resin composition sheet can be prevented from being damaged. From the above viewpoints, the pressure in the vacuum environment during heating and pressurizing the heat conductive resin composition sheet is preferably 0.1 to 5 kPa and more preferably 0.1 to 3 kPa. A heating temperature of the heat conductive resin composition sheet is preferably 120 to 200°C and more preferably 130 to 180°C. The pressure at which the heat conductive resin composition sheet is pressurized is preferably 80 to 250 kg/cm² and more preferably 100 to 200 kg/cm².

### Examples

The present invention will be explained below in detail with reference to Examples and Comparative Examples. The present invention is not limited to the following Examples.

### (Partial Discharge Start Voltage)

The partial discharge start voltage of the heat dissipation sheet was measured in accordance with JEC-0401-1990 (partial discharge measurement) under the conditions below.

Test equipment: tuning type corona measuring instrument (manufactured by Nihon Keisokuki Seizosho Co., Ltd., trade name "CD-6 type partial discharge measuring instrument")
Detection charge: 10 pc

### (Particle Size Distribution)

The particle size distribution of the boron nitride powder was measured using a laser diffraction scattering particle size analyzer (LS-13 320) manufactured by Beckman Coulter, Inc. From the obtained particle size distribution, particle sizes at the first to third maximum points (first to third maximum values), integrated quantities of frequency (first to third integrated quantities of frequency) between the peak start and the peak end in the peaks including the first to third maximum points, the absolute value (distance between D10 and the first minimum value) of the difference between the particle size at which the integrated quantity of the frequency reaches 10%, and the particle size at the minimum point between the maximum point at which the particle size is the smallest and the maximum point at which the particle size is the second smallest, the absolute value (distance between the minimum values) of the difference between the particle size at the first minimum point and the particle size at the second minimum point, and the half-value width (half-value width of maximum value 3) of the peak including the third maximum point were obtained.

### (Crushing Strength)

Crushing strength of the aggregated boron nitride particles was measured in accordance with JIS R1639-5: 2007. Specifically, the aggregated boron nitride particles were scattered on a sample stage of a microcompression tester ("MCT-W500" manufactured by Shimadzu Corporation), five aggregated boron nitride particles were selected, and each one particle was subjected to a compression test. Then, crushing strength (σ: MPa) was calculated by a formula σ = α × P / (π × d²) from a dimensionless number (α = 2.48) variable according to a position in the particle, crushing test force (P: N), and a particle size (d: pm). The crushing strengths of five inorganic filler components were subjected to Weibull plotting in accordance with JIS R1625: 2010 and crushing strength at which a cumulative damage rate reached 63.2% was determined as the crushing strength of the aggregated boron nitride particles.

Evaluations below were performed on the heat dissipation sheets of Examples and Comparative Examples.

### (Insulation Property)

A dielectric breakdown voltage of the heat dissipation sheet was evaluated based on a value measured in accordance with the method described in JIS C2110-1: 2016 by a short-time breakdown test (room temperature: 23°C). The results are shown in Table 1.

Evaluation criterion for insulation property is equal to or less than the thickness.
⊚: dielectric breakdown voltage is 10 kV or more
○: dielectric breakdown voltage is 5 kV or more and less than 10 kV
×: dielectric breakdown voltage is less than 5 kV

### (Heat Conductivity)

A heat resistance of the heat dissipation sheet was evaluated based on a value measured in accordance with the method described in ASTM D5470: 2017. The results are shown in Table 1.

Evaluation criterion for heat conductivity is as below.
⊚: heat conductivity is 5 W/(m·K) or more
○: heat conductivity is 3 W/(m·K) or more and less than 5 W/(m K)
×: heat conductivity is less than 3 W/(m K)

Boron nitride powders A to I having one maximum point as a raw material of the boron nitride powder having the plural maximum points were prepared as below.

### (Boron Nitride Powder A)

Boron nitride powder A was prepared through a boron carbide synthesis, a pressurized nitridation step, and a decarburization-crystallization step as below.

### (Boron Carbide Synthesis)

100 parts by mass of orthoboric acid (hereinafter, boric acid) manufactured by Nippon Denko Co., Ltd. and 35 parts by mass of acetylene black (HS100) manufactured by Denka Company Limited were mixed using a Henschel mixer. The obtained mixture was filled in a graphite crucible and heated in an arc furnace in an argon atmosphere at 2200°C for 5 hours to synthesize boron carbide (B₄C). The synthesized boron carbide lump was pulverized with a ball mill for 1 hour, sieved with a sieve mesh into a particle size of 75 pm or less, washed with aqueous nitric acid solution to remove impurities such as iron, and filtered and dried to prepare boron carbide powder having an average particle size of 4 pm.

### (Pressurized Nitridation Step)

The synthesized boron carbide was filled in a boron nitride crucible and then heated using a resistance heating furnace in a nitrogen gas atmosphere under the conditions of 2000°C and 9 atmospheres (0.8 MPa) for 10 hours to obtain boron carbonitride (B₄CN₄).

### (Decarburization-Crystallization Step)

100 parts by mass of the synthesized boron carbonitride and 90 parts by mass of boric acid were mixed using a Henschel mixer. The obtained mixture was filled in a boron nitride crucible, the temperature was raised at a rate of 10°C/min from the room temperature to 1000°C and at a rate of 2°C/min from 1000°C using a resistance heating furnace under the pressure condition of 0.2 MPa in a nitrogen gas atmosphere, and heating was performed at a firing temperature of 2020°C for a retaining time of 10 hours to synthesize aggregated boron nitride particles in a lump shape formed by an aggregation of primary particles. The synthesized aggregated boron nitride particles were disintegrated with a Henschel mixer for 15 minutes, and classified using a sieve mesh and with a nylon sieve having a sieve opening of 150 pm. Boron nitride powder A was obtained by disintegrating and classifying the fired product.

The average particle size (D50) of the obtained boron nitride powder A measured by a laser scattering method was 4.5 pm. According to an SEM observation, the obtained boron nitride powder A was scaly particles.

### (Boron Nitride Powder B)

Boron nitride powder B was prepared in the same manner as the boron nitride powder A except that boron carbide powder having an average particle size of 6 pm was used. The average particle size (D50) of the obtained boron nitride powder B measured by a laser scattering method was 8.0 pm. According to an SEM observation, the obtained boron nitride powder B was scaly particles.

### (Boron Nitride Powder C)

Boron nitride powder C was prepared in the same manner as the boron nitride powder A except that boron carbide powder having an average particle size of 1 pm was used. The average particle size (D50) of the obtained boron nitride powder C measured by a laser scattering method was 1.0 pm. According to an SEM observation, the obtained boron nitride powder C was scaly particles.

### (Boron Nitride Powder D)

Boron nitride powder D was prepared in the same manner as the boron nitride powder A except that boron carbide powder having an average particle size of 15 pm was used. The average particle size (D50) of the obtained boron nitride powder D measured by a laser scattering method was 23 pm. According to the result of an SEM observation, the obtained boron nitride powder D was aggregated particles formed by an aggregation of primary particles.

### (Boron Nitride Powder E)

Boron nitride powder E was prepared in the same manner as the boron nitride powder A except that boron carbide powder having an average particle size of 25 pm was used. The average particle size (D50) of the obtained boron nitride powder E measured by a laser scattering method was 35 pm. According to the result of an SEM observation, the obtained boron nitride powder E was aggregated particles formed by an aggregation of primary particles.

### (Boron Nitride Powder F)

Boron nitride powder F was prepared in the same manner as the boron nitride powder A except that boron carbide powder having an average particle size of 10 pm was used. The average particle size (D50) of the obtained boron nitride powder F measured by a laser scattering method was 15 pm. According to the result of an SEM observation, the obtained boron nitride powder F was aggregated particles formed by an aggregation of primary particles.

### (Boron Nitride Powder G)

Boron nitride powder G was prepared in the same manner as the boron nitride powder A except that boron carbide powder having an average particle size of 12 pm was used. The average particle size (D50) of the obtained boron nitride powder G measured by a laser scattering method was 18 pm. According to the result of an SEM observation, the obtained boron nitride powder L was aggregated particles formed by an aggregation of primary particles.

### (Boron Nitride Powder H)

Boron nitride powder H was prepared in the same manner as the boron nitride powder A except that boron carbide powder having an average particle size of 55 pm was used. The average particle size (D50) of the obtained boron nitride powder H measured by a laser scattering method was 78 pm. According to the result of an SEM observation, the obtained boron nitride powder H was aggregated particles formed by an aggregation of primary particles. The peak of the particle size distribution of the boron nitride powder H had a half-value width of 46 pm.

### (Boron Nitride Powder I)

Boron nitride powder I was prepared in the same manner as the boron nitride powder A except that boron carbide powder having an average particle size of 70 pm was used. The average particle size (D50) of the obtained boron nitride powder I measured by a laser scattering method was 95 pm. According to the result of an SEM observation, the obtained boron nitride powder I was aggregated particles formed by an aggregation of primary particles. The peak of the particle size distribution of the boron nitride powder I had a half-value width of 53 pm.

### (Boron Nitride Powder J)

Boron nitride powder J was prepared in the same manner as the boron nitride powder A except that boron carbide powder having an average particle size of 40 pm was used. The average particle size (D50) of the obtained boron nitride powder J measured by a laser scattering method was 55 pm. According to the result of an SEM observation, the obtained boron nitride powder J was aggregated particles formed by an aggregation of primary particles. The peak of the particle size distribution of the boron nitride powder J had a half-value width of 28 pm.

### (Boron Nitride Powder K)

Boron nitride powder K was prepared in the same manner as the boron nitride powder A except that boron carbide powder having an average particle size of 65 pm was used. The average particle size (D50) of the obtained boron nitride powder K measured by a laser scattering method was 82 pm. According to the result of an SEM observation, the obtained boron nitride powder K was aggregated particles formed by an aggregation of primary particles. The peak of the particle size distribution of the boron nitride powder K had a half-value width of 45 pm.

### (Boron Nitride Powder L)

Boron nitride powder L was prepared in the same manner as the boron nitride powder A except that boron carbide powder having an average particle size of 50 pm was used. The average particle size (D50) of the obtained boron nitride powder L measured by a laser scattering method was 73 pm. According to the result of an SEM observation, the obtained boron nitride powder L was aggregated particles formed by an aggregation of primary particles. The peak of the particle size distribution of the boron nitride powder K had a half-value width of 48 pm.

Boron nitride powders A to L were mixed at the blending ratio shown in Table 1 to prepare boron nitride powders 1 to 5.

**Table 1**

| Boron nitride powder raw material | Boron nitride powder 1 | Boron nitride powder 2 | Boron nitride powder 3 | Boron nitride powder 4 | Boron nitride powder 5 |
|---|---|---|---|---|---|
| Boron nitride powder A (parts by volume) | 10 | - | - | - | 20 |
| Boron nitride powder B (parts by volume) | - | 20 | - | - | - |
| Boron nitride powder C (parts by volume) | - | - | 5 | - | - |
| Boron nitride powder D (parts by volume) | 30 | - | - | - | - |
| Boron nitride powder E (parts by volume) | - | - | 20 | - | - |
| Boron nitride powder F (parts by volume) | - | 35 | - | - | - |
| Boron nitride powder G (parts by volume) | - | - | - | 40 | - |
| Boron nitride powder H (parts by volume) | 60 | - | - | - | - |
| Boron nitride powder I (parts by volume) | - | 45 | - | - | - |
| Boron nitride powder J (parts by volume) | - | - | 75 | - | - |
| Boron nitride powder K (parts by volume) | - | - | - | 60 | - |
| Boron nitride powder L (parts by volume) | - | - | - | - | 80 |

### (Preparation of Heat Dissipation Sheet)

60% by volume of the obtained boron nitride powder and 40% by volume of the liquid silicone resin 1 (methyl vinyl polysiloxane manufactured by Dow Toray Co., Ltd., trade name "CF-3110") relative to 100% by volume of the total of the boron nitride powder and the liquid silicone resin; 1 part by mass of a curing agent (2,5-dimethyl-2,5-bis(t-butylperoxy)hexane manufactured by Kayaku Nouryon Corporation, trade name "Trigonox 101") relative to 100 parts by mass of the silicone resin; 0.5 parts by mass of a silane coupling agent (dimethyldimethoxysilane manufactured by Dow Toray Co., Ltd., trade name "DOWSIL Z-6329 Silane", viscosity at 25°C: 1 cp) relative to 100 parts by mass of the total of the boron nitride powder; 15 parts by mass of water relative to 100 parts by mass of the silane coupling agent; and 110 parts by mass of toluene relative to 100 parts by mass of the total of the above raw materials were charged into an agitator (manufactured by HEIDON, trade name "Three-One Motor") and mixed using a turbine type agitation blade for 15 hours to prepare slurry of the heat conductive resin composition.

Then, the slurry was applied on a PET film (carrier film) having a thickness of 0.05 mm by the doctor blade method in a thickness of 1.0 mm and dried at 75°C for 5 minutes to prepare a sheet-shaped molded body having a PET film attached. On a surface of the heat conductive resin composition side of the sheet-shaped molded body obtained, a PET film having a thickness of 0.05 mm was laminated to prepare a laminated body. The laminated body had a layer structure of PET film-heat conductive resin composition-PET film. Next, the obtained laminated body was subjected to a heat press in vacuum (pressure: 3.5 kPa) under the temperature condition of 150°C at the pressure shown in Table 2 for 30 minutes. The PET films on the both surfaces were peeled off to obtain a sheet. Thereafter, the sheet was secondarily heated at normal pressure at 150°C for 4 hours to obtain the heat dissipation sheet.

The evaluation results of the obtained boron nitride powders and heat dissipation sheets are shown in Table 2.

**Table 2**

| | | Heat dissipation sheet 1 | Heat dissipation sheet 2 | Heat dissipation sheet 3 | Heat dissipation sheet 4 | Heat dissipation sheet 5 | Heat dissipation sheet 6 | Heat dissipation sheet 7 | Heat dissipation sheet 8 | Heat dissipation sheet 9 | Heat dissipation sheet 10 |
|---|---|---|---|---|---|---|---|---|---|---|---|
| | | Ex. | Ex. | Ex. | Ex. | Ex. | Ex. | Ex. | Ex. | Comp. Ex. | Comp. Ex. |
| Boron nitride powder | | Boron nitride powder 1 | Boron nitride powder 1 | Boron nitride powder 1 | Boron nitride powder 1 | Boron nitride powder 2 | Boron nitride powder 3 | Boron nitride powder 4 | Boron nitride powder 5 | Boron nitride powder 1 | Boron nitride powder 1 |
| Pressure at pressurized press (kg/cm²) | | 130 | 260 | 180 | 100 | 180 | 180 | 180 | 180 | 300 | 50 |
| | First max. value (pm) | 4.5 | 4.5 | 4.5 | 4.5 | 8 | 1 | - | 4.5 | 4.5 | 4.5 |
| | Second max. value (pm) | 23 | 23 | 23 | 23 | 15 | 35 | 18 | - | 23 | 23 |
| | Third max. value (pm) | 78 | 78 | 78 | 78 | 95 | 55 | 82 | 73 | 78 | 78 |
| | First integrated quantity of frequency (% by volume) | 10 | 10 | 10 | 10 | 20 | 5 | 0 | 20 | 10 | 10 |
| | Second integrated quantity of frequency (% by volume) | 30 | 30 | 30 | 30 | 35 | 20 | 40 | 0 | 30 | 30 |
| Evaluation results of boron nitride powder | Third integrated quantity of frequency (% by volume) | 60 | 60 | 60 | 60 | 45 | 75 | 60 | 80 | 60 | 60 |
| | Distance between D10 and first min. value (pm) | 8 | 8 | 8 | 8 | 4 | 17 | 25 | 21 | 8 | 8 |
| | Distance between min. values (µm) | 30 | 30 | 30 | 30 | 43 | 21 | - | - | 30 | 30 |
| | Half-value width of max. value 3 (µm) | 46 | 46 | 46 | 46 | 53 | 28 | 45 | 48 | 46 | 46 |
| | Crushing strength (MPa) | 8 | 8 | 8 | 8 | 12 | 6 | 9 | 10 | 8 | 8 |
| Evaluation results of heat dissipation sheet | Thickness (mm) | 0.3 | 0.3 | 0.3 | 0.3 | 0.3 | 0.3 | 0.3 | 0.3 | 0.3 | 0.3 |
| | Partial discharge start voltage (kV/mm) | 3667 | 4300 | 4267 | 3467 | 3133 | 3867 | 3733 | 3600 | 5333 | 2367 |
| | Insulation property | ○ | ⊚ | ⊚ | ○ | ○ | ○ | △ | △ | ○ | × |
| | Heat conductivity | ○ | ⊚ | ⊚ | ○ | ○ | ○ | ○ | △ | × | ○ |

From the evaluation results of the heat dissipation sheets of Examples, it was found that when the partial discharge start voltage of the heat dissipation sheet was 2800 to 5000 kV/mm, heat conductivity and insulation property of the heat dissipation sheet were improved. In addition, it was found that by using the boron nitride powder having a particle size distribution including at least the first maximum point at which the particle size is 0.4 pm or more and less than 10 pm, the second maximum point at which the particle size is 10 pm or more and less than 40 pm, and the third maximum point at which the particle size is 40 pm or more and 110 pm or less, heat conductivity and insulation property of the heat dissipation sheet were more improved.

## Claims

1. A heat dissipation sheet obtained by molding a heat conductive resin composition containing a resin and a boron nitride powder containing at least an aggregated boron nitride particle formed by an aggregation of hexagonal boron nitride primary particles,
the heat dissipation sheet having a partial discharge start voltage of 2800 to 5000 kV/mm.

2. The heat dissipation sheet according to Claim 1, wherein the boron nitride powder has a particle size distribution including at least a first maximum point, a second maximum point at which a particle size is larger than at the first maximum point, and a third maximum point at which a particle size is larger than at the second maximum point,
the particle size at the first maximum point is 0.4 pm or more and less than 10 pm,
the particle size at the second maximum point is 10 pm or more and less than 40 pm, and
the particle size at the third maximum point is 40 pm or more and 110 pm or less.

3. The heat dissipation sheet according to Claim 2, wherein an absolute value of a difference between a particle size at which an integrated quantity of a frequency in the particle size distribution of the boron nitride powder reaches 10%, and a particle size at a minimum point between a maximum point at which a particle size is the smallest and a maximum point at which a particle size is the second smallest in the particle size distribution of the boron nitride powder is 3 to 30 pm.

4. The heat dissipation sheet according to Claim 2 or 3, wherein a maximum point adjacent to the first maximum point is the second maximum point,
a maximum point adjacent to the second maximum point is the third maximum point, and
an absolute value of a difference between a particle size at a first minimum point existing between the first maximum point and the second maximum point, and a particle size at a second minimum point existing between the second maximum point and the third maximum point is 15 to 60 pm.

5. The heat dissipation sheet according to any one of Claims 2 to 4, wherein a peak including the third maximum point has a half-value width of 20 to 60 pm.

6. The heat dissipation sheet according to any one of Claims 1 to 5, wherein the aggregated boron nitride particle has a crushing strength of 5 to 18 MPa.

7. A method for producing the heat dissipation sheet according to any one of Claims 1 to 6, comprising a step of blending a resin and a boron nitride powder containing at least an aggregated boron nitride particle formed by an aggregation of hexagonal boron nitride primary particles to prepare a heat conductive resin composition,
a step of molding the heat conductive resin composition into a sheet shape to prepare a heat conductive resin composition sheet, and
a step of heating and pressurizing the heat conductive resin composition sheet under a vacuum.
